# FASCICULE DE BREVET EUROPEEN

(11) **EP 3 164 300 B1**
(45) Date de publication et mention de la délivrance du brevet: **31.10.2018**
(21) Numéro de dépôt: 15742343.5
(22) Date de dépôt: 24.06.2015
(51) Int. Cl.: B60R 16/023

(54) **ENSEMBLE DE FIXATION D'UN BOÎTIER ÉLECTRONIQUE ET D'UN ÉCRAN THERMIQUE**
BAUGRUPPE ZUR BEFESTIGUNG EINES ELEKTRONISCHEN GEHÄUSES UND EINES HITZESCHIRMS
ASSEMBLY FOR SECURING AN ELECTRONIC UNIT AND HEAT SCREEN

(30) Priorité: 01.07.2014 FR 1456259
(43) Date de publication de la demande: 10.05.2017
(73) Titulaire: PSA Automobiles SA, 78300 Poissy (FR)
(72) Inventeur: TALLET, Frederic, F-70200 Moffans Et Vacheresse (FR); BAIL, Jean-bastien, F-92100 Boulogne Billancourt (FR)
(86) Numéro de dépôt international: PCT/FR2015/051707
(87) Numéro de publication internationale: WO 2016/001532

(56) Documents cités:
- EP-A1- 1 093 954
- WO-A1-2013/179785
- DE-A1-102011 112 327
- FR-A1- 2 950 600
- FR-A1- 2 997 656
- US-A1- 2012 248 867

## Description

L'invention a trait au domaine de l'électronique embarquée sur les véhicules automobiles et plus particulièrement à la fixation de boîtiers électroniques sur une caisse d'un véhicule automobile de type utilitaire, ou assimilé, ayant une caisse à plancher plat pour offrir un grand volume utile et faciliter le déplacement d'objets sur ce plancher.

Les véhicules automobiles sont pourvus de systèmes électroniques embraqués permettant, via un ordinateur de bord, une gestion des organes du véhicule et une aide au conducteur pour contrôler le véhicule plus facilement. On pourra citer par exemple, le système permettant d'empêcher le blocage des freins en cas de freinage brusque (ABS), la direction assistée, l'anti patinage des roues sur sol glissant, l'aide à la navigation (GPS) ou pour les véhicules haut de gamme le correcteur d'assiette.

Dans le cas des véhicules à moteur diesel, la réglementation nationale et/ou continentale impose de contrôler et de limiter le rejet de polluants dans l'atmosphère. Ainsi, les véhicules diesel sont équipés d'un système de dépollution des gaz d'échappement et d'un circuit dédié au contrôle du taux de polluants rejetés dans l'atmosphère. Ces circuits dédiés comprennent généralement au moins une sonde introduite sur la ligne d'échappement du véhicule et un boîtier électronique relié d'une part à la sonde, via un câble, et d'autre part à un ordinateur de bord du véhicule, via un faisceau électrique.

Ces circuits dédiés sont généralement placés et fixés sous la caisse du véhicule de sorte à être au plus près de la ligne d'échappement. Toutefois, ces circuits dédiés doivent cohabiter avec d'autres éléments, tels qu'un faisceau électrique du véhicule, passant d'un côté du véhicule à l'autre, un câble électrique reliant le boîtier électronique à l'ordinateur de bord ou encore une durite de carburant reliant un réservoir de carburant à un moteur thermique.

A cette cohabitation qui ne va pas sans poser de problèmes d'emmêlement ou d'interférence, il faut ajouter que des éléments de protection, tel qu'un écran thermique, doivent être fixés sur le véhicule en des points de fixations précis. Ainsi, il existe une problématique quant à la fixation des différents éléments sur le véhicule.

Il est à noter toutefois que, dans le but de standardiser les pièces utilisées d'un véhicule à un autre, les constructeurs doivent trouver un moyen de fixer une même pièce sur différents véhicules. Par exemple, un écran thermique en forme de voûte doit pouvoir être fixé à la fois sur un véhicule pour particulier comprenant un tunnel pour une ligne d'échappement, et sur un véhicule de type utilitaire dépourvu d'un tel tunnel. On comprend alors qu'il existe des points de fixation en périphérie du tunnel sur un véhicule pour particulier tandis que pour un véhicule utilitaire de nouveaux points de fixation doivent être trouvés puisque ce type de véhicule est dépourvu de tunnel.

Le document FR 2 997 656 propose un ensemble pour châssis comprenant un support et un écran de protection thermique placés dans un tunnel dans lequel circule la ligne d'échappement du véhicule. Le boîtier est fixé sur le support, lui-même fixé sur l'écran thermique. Lors de la phase d'assemblage du véhicule, l'écran thermique vient recouvrir la caisse, de sorte que le boîtier électronique et le support soient placés entre la caisse du véhicule et l'écran thermique, l'écran thermique faisant à la fois barrière à la chaleur dégagée par la ligne d'échappement et aux projections.

Cet ensemble ne va cependant pas sans inconvénients.

En effet, dans ce montage antérieur, le support est fixé sur l'écran thermique. L'écran thermique, réalisé en aluminium et/ ou feutre résiné, sera amené à vibrer ou bouger en cas de secousses subies par le véhicule. Dès lors, le boîtier électronique peut heurter les parois du tunnel, au risque d'être endommagé et de ne plus fonctionner.

De plus, le support ne permet que la fixation du boîtier électronique. Dès lors, les éléments externes tels que le faisceau électrique du véhicule, le câble du boîtier électronique ou même la durite de carburant peuvent être libres de mouvement et frotter contre la caisse du véhicule et risquer de s'abîmer et même de se rompre.

Enfin, le support ne permet pas, non plus, de fixer un boîtier électronique et un écran thermique sur différents types de véhicules comme un véhicule pour particulier et un véhicule utilitaire, ces deux types de véhicules ayant des caractéristiques et des conceptions très différentes.

L'invention a pour but principal de répondre aux inconvénients de l'art antérieur.

Pour cela, un premier objectif est de proposer ensemble de fixation comprenant un support permettant la fixation d'un boîtier électronique, d'un écran thermique et d'éléments externes tels que le faisceau électrique du véhicule, un câble du boîtier électronique ou encore une durite de carburant.

Un deuxième objectif est de proposer un simple et peu coûteux de fabrication.

Un troisième objectif est de proposer un support léger et facile à monter sur le véhicule.

Un quatrième objectif est de proposer un véhicule automobile comprenant ensemble de fixation comprenant un support pour la fixation d'un boîtier électronique, d'un écran thermique et d'éléments externes tels que le faisceau électrique du véhicule, un câble du boîtier électronique ou encore une durite de carburant, répondant aux objectifs précédemment identifiés.

A cet effet, il est proposé en premier lieu un ensemble de fixation d'un boîtier électronique, cet ensemble comprenant un longeron et une traverse d'une caisse d'un véhicule automobile, la traverse et le longeron formant un plan de caisse, ainsi qu'un support comprenant une portion centrale, une première portion d'extrémité et une deuxième portion d'extrémité venant se fixer sur le longeron, le boîtier électronique étant destiné à être fixé sur une face supérieure de la portion centrale caractérisé en ce que le support est monté sur la traverse et le longeron, la première portion d'extrémité comprenant une première patte ayant une première semelle venant au contact de la traverse à une distance, mesurée entre la face supérieure de la portion centrale et le plan de caisse, strictement supérieure à une épaisseur du boîtier électronique.

Le support permet ainsi de fixer le boîtier électronique sur la caisse du véhicule tout en permettant de maintenir un écart constant avec la caisse, de sorte à empêcher tout contact entre la caisse et le boîtier électronique, ces contacts pouvant nuire au bon fonctionnement du boîtier électronique.

Diverses caractéristiques supplémentaires peuvent être prévues, seules ou en combinaison :
- la première portion d'extrémité comprend une deuxième patte pour la fixation d'un écran thermique au moyen de rivets ;
- la deuxième patte présente une hauteur telle que l'écran thermique est écarté du support ;
- la portion centrale comprend une troisième patte et une quatrième patte pour la fixation d'un faisceau électrique et d'une durite de carburant au moyen de clips ;
- la deuxième portion d'extrémité comprend une cinquième patte et une sixième patte pour la fixation d'un faisceau électrique et d'un câble du boîtier électronique au moyen de clips ;
- la ou chaque patte est réalisée par pliage par rapport à la portion à laquelle elle est raccordée ;
- la première portion d'extrémité et la deuxième portion d'extrémité sont reliées à la portion centrale par une portion inclinée pliée par rapport aux portions d'extrémités et à la portion centrale ;
- le support comprend au moins un bossage de rigidification formé sur au moins un pli.

Il est proposé en second lieu un véhicule automobile comprenant une caisse sur laquelle sont montés un écran thermique et un boîtier électronique au moyen d'un ensemble de fixation tel que précédemment décrit, le support étant monté sous le véhicule automobile.

D'autres caractéristiques et avantages de l'invention apparaîtront plus clairement et de manière concrète à la lecture de la description ci-après de modes de réalisation, laquelle est faite en référence aux dessins annexés dans lesquels :
- la figure 1 est une vue schématique en coupe d'un véhicule automobile comprenant un support pour la fixation d'un boîtier électronique et d'un écran thermique ;
- la figure 2 est une vue en perspective de dessus du support de la figure 1 sur laquelle sont également montés une durite, un faisceau électrique et un câble électrique ;
- la figure 3 est une vue de dessous du support des figures 1 et 2.

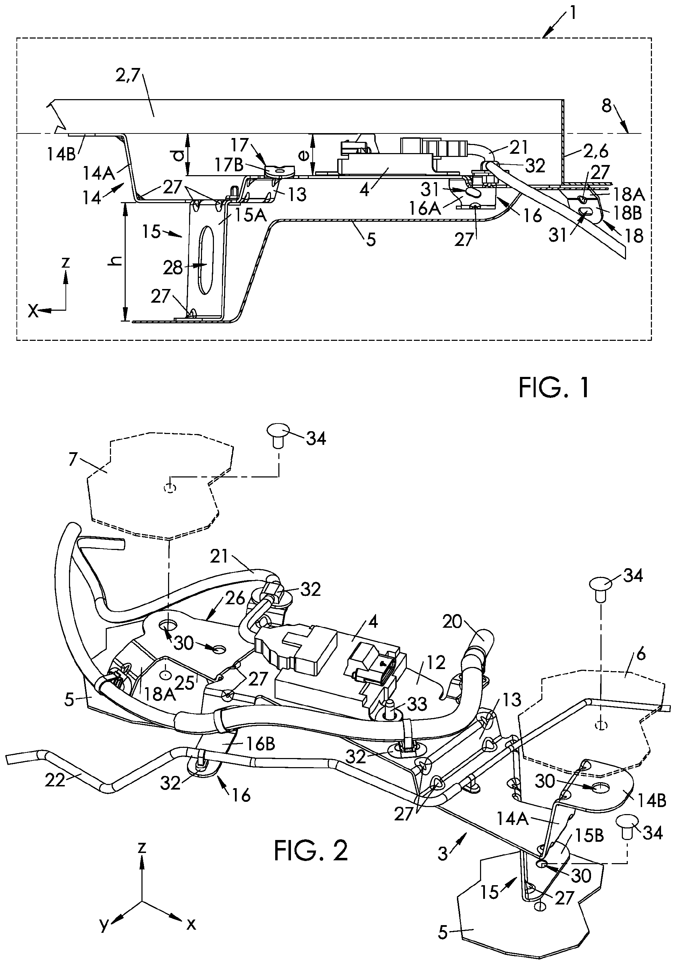

La figure 1 représente, de manière schématique, un véhicule **1** automobile comprenant une caisse **2** sur laquelle est fixé un support **3** pour la fixation d'un boîtier **4** électronique et d'un écran **5** thermique, le support **3** étant monté sous le véhicule **1.**

Plus précisément, la caisse **2** comprend un longeron **6** s'étendant sensiblement suivant une direction générale de déplacement du véhicule **1,** et une traverse **7** sensiblement perpendiculaire au longeron **6,** le longeron **6** et la traverse **7** formant un plan **8** de caisse **2.**

On définit par rapport au support **3** un repère orthogonal XYZ comprenant trois axes perpendiculaires deux à deux, à savoir :
- un axe X, définissant une direction longitudinale, horizontale, confondue avec une direction générale d'élongation du support **3,**
- un axe Y, définissant une direction transversale, horizontale, qui avec l'axe X définit un plan XY horizontal,
un axe Z, définissant une direction verticale, perpendiculaire au plan XY horizontal.

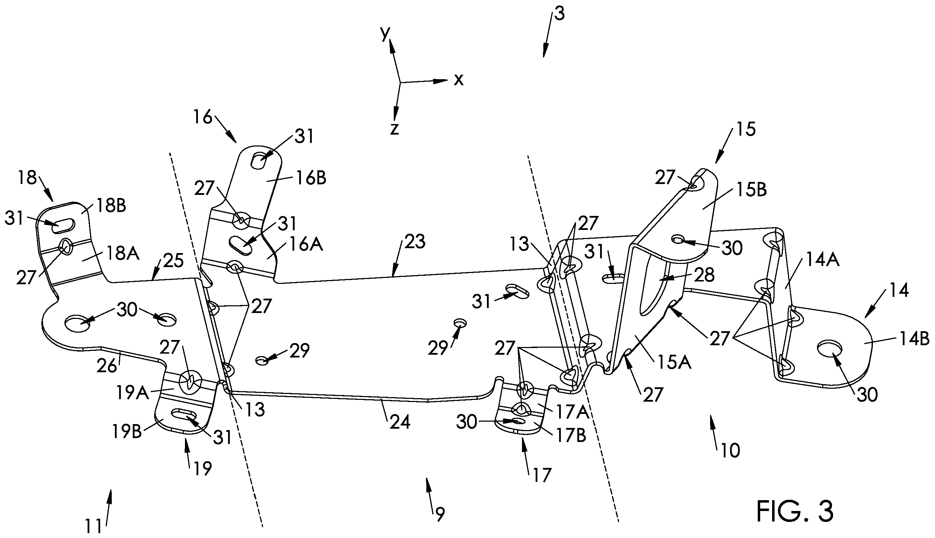

Le support, particulièrement visible sur la figure 3, comprend une portion **9** centrale, une première portion **10** d'extrémité venant se fixer sur la traverse **7** et sur laquelle est fixé l'écran **5** thermique, et une deuxième portion **11** d'extrémité venant se fixer sur le longeron **6** et sur laquelle est également fixé l'écran **5** thermique.

La portion **9** centrale est plane et de forme sensiblement rectangulaire, définissant la direction générale d'élongation du support **3,** cette portion **9** centrale comprend une face **12** supérieure sur laquelle est fixé le boîtier **4** électronique.

Avantageusement, la première portion **10** d'extrémité et la deuxième portion **11** d'extrémité sont sensiblement planes et parallèles à la portion **9** centrale et s'étendent de part et d'autre de la portion **9** centrale.

Comme on le voit sur la figure 3, les deux portions **10, 11** d'extrémité sont décalées, suivant l'axe Z, par rapport à la portion **9** centrale, les portions **10, 11** d'extrémité étant raccordées à la portion **9** centrale par des portions **13** inclinées.

Afin de permettre la fixation du support **3** sur le véhicule **1,** d'une part, et la fixation du boîtier **4** électronique, de l'écran **5** thermique et d'éléments externes sur le support **3,** d'autre part, le support **3** comprend des pattes **14, 15, 16, 17, 18, 19** faisant saillie de la portion **9** centrale et des portions **10, 11** d'extrémité. Par éléments externes, on entend un faisceau **20** électrique du véhicule **1,** un câble **21** électrique reliant le boîtier **4** électronique à un ordinateur de bord (non représenté) ou encore une durite **22** de carburant reliant le réservoir de carburant à un moteur thermique.

Avantageusement le support **3** comprend six pattes **14, 15, 16, 17, 18, 19** réparties par paires sur chaque portion **9, 10, 11** de la manière décrite ci-après, chaque patte **14, 15, 16, 17, 18, 19** comprenant une âme **14A, 15A, 16A, 17A, 18A, 19A** et une semelle **14B, 15B, 16B, 17B, 18B, 19B** repliée par rapport à l'âme **14A, 15A, 16A, 17A, 18A, 19A,** et étant raccordée à sa portion **9, 10, 11** par son âme **14A, 15A, 16A, 17A, 18A, 19A.**

Pour faciliter la lecture de la description et sa compréhension, l'âme **14A, 15A, 16A, 17A, 18A, 19A** et la semelle **14B, 15B, 16B, 17B, 18B, 19B** de chaque patte **14, 15, 16, 17, 18, 19** reprendra l'adjectif de chaque patte à laquelle elle appartient de sorte que, par exemple, la première patte **14** comprend une première âme **14A** et une première semelle **14B,** la cinquième patte **18** comprend une cinquième âme **18A** et une cinquième semelle **18B.**

La première portion **10** d'extrémité comprend la première patte **14** et la deuxième patte **15.** La première patte **14** fait saillie de la première portion **10** d'extrémité, sensiblement suivant l'axe Z, la première semelle **14B** étant sensiblement parallèle à la première portion **10** d'extrémité. La deuxième patte **15** fait également saillie de la première portion **10** d'extrémité, à proximité d'une jonction entre la portion **13** inclinée et la première portion **10** d'extrémité, dans une direction opposée à la première patte **14,** la deuxième semelle **15B** étant sensiblement parallèle à la première semelle **14B.**

De préférence, la première patte **14** s'étend sur une hauteur telle que la première semelle **14B** venant au contact de la traverse **7** de la caisse **2** soit à une distance **d,** mesurée entre la face **12** supérieure de la portion **9** centrale et le plan **8** de caisse **2,** strictement supérieure à une épaisseur **e** du boîtier **4** électronique.

Avantageusement, la deuxième patte **15** présente une hauteur **h** telle que l'écran **5** thermique est écarté du support **3** de sorte que l'écran **5** thermique ne vienne pas heurter le support **3** en cas de secousses ou de chocs subis par le véhicule **1.**

La portion **9** centrale comprend la troisième patte **16** et la quatrième patte **17.** La troisième patte **16** s'étend depuis un premier bord **23** de la portion **9** centrale suivant l'axe Z et la quatrième patte **17** s'étend dans une direction opposée depuis un deuxième bord **24** de la portion **9** centrale.

Enfin, la deuxième portion **11** d'extrémité comprend la cinquième patte **18** et la sixième patte **19.** La cinquième patte **18** s'étend depuis une première bordure **25** suivant l'axe Z et la sixième patte **19** s'étend dans une direction opposée depuis une deuxième bordure **26,** à proximité à proximité d'une jonction entre la portion **13** inclinée et la deuxième portion **11** d'extrémité.

Avantageusement le support **3** est réalisé par pliage d'une feuille de matériau métallique tel qu'un alliage d'aluminium permettant une facilité de fabrication, une bonne tenue mécanique et un faible poids.

Pour assurer une bonne tenue mécanique du support **3** et un maintenir la forme pliée du support **3,** des bossages **27** de rigidification sont formés sur les plis entre les pattes **14, 15, 16, 17, 18, 19** et les portions **9, 10, 11** ou entre les différentes portions **9, 10, 11** elles-mêmes.

Dans le but d'alléger le support **3** et de diminuer la quantité de matière nécessaire à sa réalisation, la deuxième âme **15**A de la deuxième patte **15** est pourvue d'un évidement **28.** D'autres évidements non représentés pourraient être réalisés sur les autres pattes **14, 16, 17, 18, 19,** sur la portion **9** centrale, sur la première portion **10** d'extrémité ou sur la deuxième portion **11** d'extrémité.

Comme on le voit sur les figures 2 et 3, le support **3** est muni de perçages **29,** de trous **30** et d'ouvertures **31** aptes à recevoir un clip **32,** une vis **33** ou un rivet **34.**

Plus précisément, les ouvertures **31** sont de formes oblongues et sont aptes à recevoir un clip **32,** les perçages **29** sont taraudés de sorte à recevoir une vis **33** en prise hélicoïdale et les trous **30,** réalisés sur la première semelle **14B** de la première patte **14** et sur la deuxième portion **11** d'extrémité, sont aptes à recevoir un rivet **34.**

Lorsque le support **3** est monté sur le véhicule **1,** la première semelle **14B** et la deuxième portion **11** d'extrémité viennent respectivement au contact de la traverse **7** et du longeron **6** de la caisse **2** au moyen de rivets **34,** rendant ainsi le support **3** sensiblement parallèle au plan **8** de la caisse **2.**

Le boîtier **4** électronique, l'écran **5** thermique et les éléments externes viennent être fixés sur le support **3** comme suit:
- le boîtier **4** électronique est fixé sur la face **12** supérieure de la portion **9** centrale au moyen des vis **33** venant en prise hélicoïdale dans les perçages **29** de la portion **9** centrale ;
- l'écran **5** thermique vient se fixer sur la deuxième portion **11** d'extrémité et sur la deuxième semelle **15B** de la deuxième patte **15** au moyen de rivets **34** venant dans les trous **30,** et
- le faisceau **20** électrique du véhicule **1,** le câble **21** électrique et la durite **22** de carburant sont fixés au support **3,** aux pattes **14,15, 16, 17, 18, 19** et aux différentes portions **9, 10, 11** au moyen de clips **32** venant dans les trous **30** ou les ouvertures **31.**

Avantageusement, les ouvertures **31** sont de forme oblongue pour permettre un réglage de la fixation des clips **32** sur le support **3** de sorte à empêcher un parcours trop sinueux au faisceau **20** électrique du véhicule **1,** au câble **21** électrique et à la durite **22** de carburant.

Selon le mode de réalisation représenté sur les dessins, deux clips **32** successifs, fixant un même élément externe, sont écartés d'une distance comprise entre 200 mm et 300 mm et de préférence d'une distance comprise entre 175mm et 250mm. Ainsi, deux trous **30** et/ou ouvertures **31** successifs(ves) dans lesquels viennent se loger deux clips **32** successifs fixant un même élément externe, sont écartés d'une distance comprise entre 200 mm et 300mm.

Le support **3** qui vient d'être décrit présente un grand nombre d'avantages.

Tout d'abord, le support **3** permet la fixation d'un boîtier **4** électronique, d'un écran **5** thermique et d'éléments externes tels que le faisceau **20** électrique du véhicule **1,** un câble **21** du boîtier **4** électronique ou encore une durite **22** de carburant. Ainsi, il est possible de limiter le nombre de trous réalisés dans la caisse **2** du véhicule **1** pour fixer les éléments externes indépendamment du boîtier **4** électronique et de l'écran **5** thermique. De fait, l'assemblage et la fabrication du véhicule **1** sont facilités et sont plus rapides.

Par ailleurs, le support **3** permet de maintenir un écartement constant entre le boîtier **4** électronique et le plan **8** de la caisse **2** d'une part, et entre le support **3** et l'écran **5** thermique d'autre part. Ainsi, le boîtier **4** électronique et l'écran **5** thermique sont protégés des secousses et des chocs contre la caisse **2** ou le support **3,** au bénéfice de l'augmentation de leur durée de vie.

De plus, ce support **3** est simple et peu coûteux de fabrication. En effet, le support **3** est réalisé par pliage ce qui permet de le réaliser par emboutissage ou estampage par exemple, ces modes de fabrication pouvant être entièrement automatiques.

Enfin, le support **3** est léger et facile à monter sur le véhicule **1.** Le matériau constituant le support **3** permet d'assurer la légèreté et donc la manipulation du support **3,** et le montage du support **3** sur le véhicule **1** se fait par l'utilisation de rivets **34** faciles et rapides à mettre en oeuvre.

## Revendications

1. Ensemble de fixation d'un boîtier (**4**) électronique, cet ensemble comprenant un longeron (**6**) et une traverse (**7**) d'une caisse (**2**) d'un véhicule (**1**) automobile, la traverse (**7**) et le longeron (**6**) formant un plan (**8**) de caisse, ainsi qu'un support comprenant une portion (**9**) centrale, une première portion (**10**) d'extrémité et une deuxième portion (**11**) d'extrémité venant se fixer sur le longeron (**6**), le boîtier (**4**) électronique étant destiné à être fixé sur une face (**12**) supérieure de la portion (**9**) centrale, **caractérisé en ce que** le support (**3**) est monté sur la traverse (**7**) et le longeron(**6**), la première portion (**10**) d'extrémité comprenant une première patte (**14**) ayant une première semelle (**14B**) venant au contact de la traverse (**7**) à une distance (**d**), mesurée entre la face (**12**) supérieure de la portion (**9**) centrale et le plan (**8**) de caisse (**2**), strictement supérieure à une épaisseur (**e**) du boîtier (**4**) électronique.

2. Ensemble selon la revendication 1 **caractérisé en ce que** la première portion (**10**) d'extrémité comprend une deuxième patte (**15**) pour la fixation d'un écran (**5**) thermique au moyen de rivets (**34**).

3. Ensemble selon la revendication 2 **caractérisé en ce que** la deuxième patte (**15**) présente une hauteur (**h**) telle que l'écran (**5**) thermique est écarté du support (**3**).

4. Ensemble selon l'une quelconque des revendications précédentes **caractérisé en ce que** la portion (**9**) centrale comprend une troisième patte (**16**) et une quatrième patte (**17**) pour la fixation d'un faisceau (**20**) électrique et d'une durite (**22**) de carburant au moyen de clips (**32**).

5. Ensemble selon l'une quelconque des revendications précédentes **caractérisé en ce que** la deuxième portion (**11**) d'extrémité comprend une cinquième patte (**18**) et une sixième patte (**19**) pour la fixation d'un faisceau (**20**) électrique et d'un câble du boîtier (**4**) électronique au moyen de clips (**32**).

6. Ensemble selon l'une quelconque des revendications précédentes **caractérisé en ce que** la ou chaque patte (**14, 15, 16, 17, 18, 19**) est réalisée par pliage par rapport à la portion à laquelle elle est raccordée.

7. Ensemble selon l'une quelconque des revendications précédentes **caractérisé en ce que** la première portion (**10**) d'extrémité et la deuxième portion (**11**) d'extrémité sont reliées à la portion (**9**) centrale par une portion (**13**) inclinée pliée par rapport aux portions (**10, 11**) d'extrémités et à la portion (**9**) centrale.

8. Ensemble selon l'une quelconque des revendications précédentes, **caractérisé en ce que** celui-ci comprend au moins un bossage (**27**) de rigidification formé sur au moins un pli.

9. Véhicule (**1**) automobile comprenant une caisse (**2**) sur laquelle sont montés un écran (**5**) thermique et un boîtier (**4**) électronique au moyen d'un ensemble de fixation selon l'une quelconque des revendications précédentes le support étant monté sous le véhicule (**1**) automobile.

## Patentansprüche

1. Baugruppe zur Befestigung eines elektronischen Gehäuses (4), wobei diese Baugruppe einen Längsträger (6) und einen Querträger (7) einer Karosserie (2) eines Kraftfahrzeugs (1) umfasst, wobei der Querträger (7) und der Längsträger (6) eine Karosserieebene (8) bilden, sowie einen Träger, der einen zentralen Abschnitt (9), einen ersten Endabschnitt (10) und einen zweiten Endabschnitt (11), die an dem Längsträger (6) befestigt sind, umfasst, wobei das elektronische Gehäuse (4) dazu bestimmt ist, auf einer oberen Seite (12) des zentralen Abschnitts (9) befestigt zu sein, **dadurch gekennzeichnet, dass** der Träger (3) auf dem Querträger (7) und dem Längsträger (6) montiert ist, wobei der erste Endabschnitt (10) eine erste Pratze (14) umfasst, die eine erste Sohle (14B) hat, die mit dem Querträger (7) in einem Abstand (d), der zwischen der Oberseite (12) des zentralen Abschnitts (9) und der Ebene (8) der Karosserie (2) gemessen strikt größer als eine Stärke (e) des elektronischen Gehäuses (4) ist, in Berührung kommt.

2. Baugruppe nach Anspruch 1, **dadurch gekennzeichnet, dass** der erste Endabschnitt (10) eine zweite Pratze (15) zur Befestigung eines Hitzeschilds (5) mittels Nieten (34) umfasst.

3. Baugruppe nach Anspruch 2, **dadurch gekennzeichnet, dass** die zweite Pratze (15) eine Höhe (h) derart aufweist, dass der Hitzeschild (5) von dem Träger (3) beabstandet ist.

4. Baugruppe nach einem der vorhergehenden Ansprüche, **dadurch gekennzeichnet, dass** der zentrale Abschnitt (9) eine dritte Pratze (16) und eine vierte Pratze (17) für die Befestigung eines Kabelbündels (20) und eines Kraftstoffschlauchs (22) mittels Clips (32) umfasst.

5. Baugruppe nach einem der vorhergehenden Ansprüche, **dadurch gekennzeichnet, dass** der zweite Endabschnitt (11) eine fünfte Pratze (18) und eine sechste Pratze (19) für die Befestigung eines Kabelbündels (20) und eines Kabels des elektronischen Gehäuses (4) mittels Clips (32) umfasst.

6. Baugruppe nach einem der vorhergehenden Ansprüche, **dadurch gekennzeichnet, dass** die oder jede Pratze (14, 15, 16, 17, 18, 19) durch Falten in Bezug auf den Abschnitt, an den sie angeschlossen ist, hergestellt ist.

7. Baugruppe nach einem der vorhergehenden Ansprüche, **dadurch gekennzeichnet, dass** der erste Endabschnitt (14) und der zweite Endabschnitt (11) mit dem zentralen Abschnitt (9) durch einen schrägen Abschnitt (13) verbunden sind, der in Bezug auf die Endabschnitte (10, 11) und den zentralen Abschnitt (9) gefaltet ist.

8. Baugruppe nach einem der vorhergehenden Ansprüche, **dadurch gekennzeichnet, dass** sie mindestens einen Versteifungshöcker (27), der auf mindestens einer Faltung gebildet ist, umfasst.

9. Kraftfahrzeug (1), das eine Karosserie (2) umfasst, auf der ein Hitzeschild (5) und ein elektronisches Gehäuse (4) mit einer Befestigungsbaugruppe nach einem der vorhergehenden Ansprüche montiert sind, wobei der Träger unter dem Kraftfahrzeug (1) montiert ist.

## Claims

1. An assembly for securing an electronic unit (4), this assembly including a longitudinal member (6) and a cross member (7) of a body shell (2) of a motor vehicle (1), the cross member (7) and the longitudinal member (6) forming a body shell plane (8), and also a support including a central portion (9), a first end portion (10) and a second end portion (11) coming to be attached on the longitudinal member (6), the electronic unit (4) being intended to be attached on an upper face (12) of the central portion (9), **characterized in that** the support (3) is mounted on the cross member (7) and the longitudinal member (6), the first end portion (10) including a first tab (14) having a first soleplate (14B) coming in contact with the cross member (7) at a distance (d), measured between the upper face (12) of the central portion (9) and the plane (8) of body shell (2), strictly greater than a thickness (e) of the electronic unit (4).

2. The assembly according to Claim 1, **characterized in that** the first end portion (10) includes a second tab (15) for the attachment of a heat screen (5) by means of rivets (34).

3. The assembly according to Claim 2, **characterized in that** the second tab (15) has a height (h) such that the heat screen (5) is spaced apart from the support (3) .

4. The assembly according to any one of the preceding claims, **characterized in that** the central portion (9) includes a third tab (16) and a fourth tab (17) for the attachment of a wiring harness (20) and a fuel hose (22) by means of clips (32).

5. The assembly according to any one of the preceding claims, **characterized in that** the second end portion (11) includes a fifth tab (18) and a sixth tab (19) for the attachment of a wiring harness (20) and a cable of the electronic unit (4) by means of clips (32) .

6. The assembly according to any one of the preceding claims, **characterized in that** the or each tab (14, 15, 16, 17, 18, 19) is formed by bending with respect to the portion to which it is connected.

7. The assembly according to any one of the preceding claims, **characterized in that** the first end portion (10) and the second end portion (11) are connected to the central portion (9) by an inclined portion (13), bent with respect to the end portions (10, 11) and the central portion (9).

8. The assembly according to any one of the preceding claims, **characterized in that** the latter includes at least one stiffening boss (27) formed on at least one fold.

9. A motor vehicle (1) including a body shell (2) on which are mounted a heat screen (5) and an electronic unit (4) by means of an attachment assembly according to any one of the preceding claims, the support being mounted underneath the motor vehicle (1).
